# EUROPEAN PATENT APPLICATION

(11) **EP 1 240 971 A2**
(43) Date of publication of application: **18.09.2002**
(21) Application number: 02251155.4
(22) Date of filing: 20.02.2002
(51) Int. Cl.: B23K 26/20, G02B 6/30

(54) **Laser welding components to a micro-optical bench**

(30) Priority: 26.02.2001 US 791723
(71) Applicant: JDS Uniphase Inc., Nepean, Ontario K2G 5W8 (CA)
(72) Inventor: Musk, Robert W., Kingston, Kingsbridge, Devon TQ7 4PF (GB)
(74) Representative: McKechnie, Neil

(57) **Abstract**

Many optical components now use a microelectronic substrate called an optical micro-bench as a base from which to build. Conventional devices use one or more methods of fixing the various elements together and/or onto the semiconductor micro-bench. Typically these conventional methods require special coatings to be deposited on the substrate, and the use of a separate bonding material, e.g. solder, glass or adhesive. The present invention relates to the direct fixation of a semiconductor, e.g. silicon, indium phosphide or gallium arsenide, structural component to the micro-bench made of a similar material using a laser welding technique, which uses wavelengths that are not harmful to the other elements of the component. The present invention eliminates the use of any separate bonding material, as well as several steps in the bonding process.

## Description

The present invention relates to the fixation of structural components to a substrate, and in particular to the laser welding of a semiconductor material, e.g. silicon, indium phosphide (InP), and gallium arsenide (GaAs), structural components to a like substrate, used in the fiber-optics industry.

### BACKGROUND OF THE INVENTION

The basic building block for many of the new fiber optics devices is a semiconductor-based substrate commonly known as an optical micro-bench. Optical components, such as lenses, amplifiers and switches, are mounted on the optical microbench, while the ends of optical fibers are fixed to the optical micro-bench in optical alignment with the components. Two major concerns when using optical micro-benches are: the alignment of the fibers, and the hermetic sealing of the components. Up until now these concerns have been addressed using several very different techniques.

Optical fiber alignment techniques are divided into two classes, passive and active. Passive alignment techniques usually rely on grooves etched in the micro-bench using very strict tolerances. Alternatively, separate structural components, which are positioned relative to the micro-bench using one of a variety of visual or structural keys, can also be used. In the method disclosed in United States Patent No. 6,118,917 issued September 12, 2000 to Lee et al, the separate structural components are aligned using alignment platforms, which include corresponding bumps and grooves. The structural components are fixed to the micro-bench using an optical adhesive or by welding metal plates, previously deposited on corresponding surfaces.
In active alignment techniques the fiber is moved relative to the optical component until optical coupling above a certain level is measured. Subsequently, the fiber is fixed to the micro-bench. In the method disclosed in United States Patent No. 4,702,547 issued October 27, 1987 to Enochs, Scott R metal layers and pads coated on the various elements are required to fix everything together. In the method disclosed in United States Patent No. 5,210,811 issued May 11, 1993 to Avelange et al, metal aligning plates are laser soldered to a metal sleeve surrounding an optical fiber, after the fiber has been aligned with a laser. United States Patent No. 5,319,729 issued June 7, 1994 to Allen et al discloses an alignment technique in which silica fibers are welded directly to a silica block. This patented method necessitates the use of a CO₂ laser to raise the temperature of the block to over 2000 °C, which causes all of the elements subjected to the laser to locally deform.

Similarly, in the area of hermetic sealing, various techniques have been used to seal a casing around an optical component. Most of the prior art techniques, including the one disclosed in United States Patent No 6,074,104 issued June 13, 2000 to Higashikawa, relate to fixing structural components of different materials using some form of adhesive, e.g. solder, glue, low-melting glass. Typically, special coatings or plates are required to enable the various elements to bond. Alternatively, as disclosed in United States Patent No. 4,400,870 issued August 30, 1983 to Islam, a separate housing is provided to encapsulate the substrate. In this case a separate plate is needed to mount the substrate to the housing.

Another example of a method of fixing a structural component to a micro-bench is disclosed in United States Patent No 5,995,688, wherein a structural component is fixed to the micro-bench using solder, which connects predisposed bonding sites on the structural component to corresponding predisposed bonding sites on the microbench.

As evidenced by the aforementioned examples, the prior art alignment and hermetic sealing techniques utilize a variety of different labor-intensive methods to fix the various elements together. Most of these examples require special metal coatings or plates and usually require some form of separate bonding medium.

An object of the present invention is to overcome the shortcomings of the prior art by providing a method of fixing a semiconductor structural component, e.g. one made of silicon, InP or GaAs, to a micro-bench of similar material without the need for specially interposed mounting surfaces, without the need for a separate bonding material, and without the need for laser wavelengths and excessive temperatures harmful to the remainder of the elements.

Another object of the present invention is to provide a method for hermetically sealing an optical component on a semiconductor micro-bench, by directly joining a semiconductor cap to the micro-bench, thereby hermetically sealing the optical component therein.

### SUMMARY OF THE INVENTION

Accordingly, the present invention relates to a method of fixing a first semiconductor component to a second semiconductor component comprising the steps of:
a) providing a first semiconductor component, such as a micro-bench, typically for supporting an optical element;
b) providing a second semiconductor structural component, typically for fixation to the microbench;
c) positioning the first semiconductor component in close proximity to the second semiconductor component establishing a fixation area, where the first and second semiconductor components will be joined together; and
d) directing an optical beam at the fixation area with sufficient power to fix adjacent portions on both first and second semiconductor components together.

### BRIEF DESCRIPTION OF THE DRAWINGS

The invention will be described in greater detail with reference to the accompanying drawings, which illustrate preferred embodiments of the invention, wherein:
Figures 1 to 3 illustrate several laser welded melt runs using the laser parameters detailed in Table 1;
Figure 4 illustrates the difference in weld quality between a weld conducted in an air atmosphere and a weld conducted in an inert (argon) atmosphere;
Figures 5 and 6 illustrate the method of the present invention involving a passive alignment technique;
Figure 7 is a plan view of a device resulting from the use of the method of the present invention involving an active alignment technique;
Figure 8 is a side view of a device resulting from the use of the method of the present invention involving a hermetic sealing technique; and
Figure 9 is a plan view of the device of Fig. 8.

### DETAILED DESCRIPTION

The following description refers specifically to silicon, however, the same basic principles hold true for all semiconductor materials.

Silicon is a brittle material - being crystalline, the ductility is essentially zero. Moreover, in typical metals, the density of the molten form is lower than that of the solid at the same temperature by 5-10%. However, in Silicon the reverse situation applies, with the liquid form having a higher density than the solid by about 8%. This phenomenon is likely to lead to a rather different crack formation mechanism. In metals, cracks and voids can occur if the cooling and contracting molten material fails to fully flow back towards the melt center before it solidifies. This can be controlled to some extent by external parameters controlling the cooling rates. The surface stresses in welded metals, therefore, tend to be tensile.

In general very high power short pulses lasers tend to drill into the silicon, while low power, long pulse lasers cause severe ablation and cracking. Typically, CO₂ lasers at wavelengths of between 9000 and 11000 nm are used for welding applications, e.g. for silica, due to the high powers obtainable thereby. However, silicon is effectively transparent to wavelengths above 1200 nm. There will be some absorption above this wavelength level, but very high power levels will be required to obtain the required melt condition. Accordingly, the choice of lasers is usually limited to ones from ultraviolet (150 nm) up to 5000 nm, including more commonly available lasers such as pulsed Copper Vapor Lasers (CVL) at 511 nm or 589 nm, doubled frequency Neodymium:Yttrium Aluminum Garnet (Nd:YAG) lasers at 532 nm, and continuous wave (CW) or pulsed Nd:YAG lasers at 1064 nm. The optical window for the other semiconductor materials, e.g. InP and GaAs, will be slightly different and may require a different laser selection. Moreover, any optical beam that generates enough power can be used, however lasers are an obvious choice.

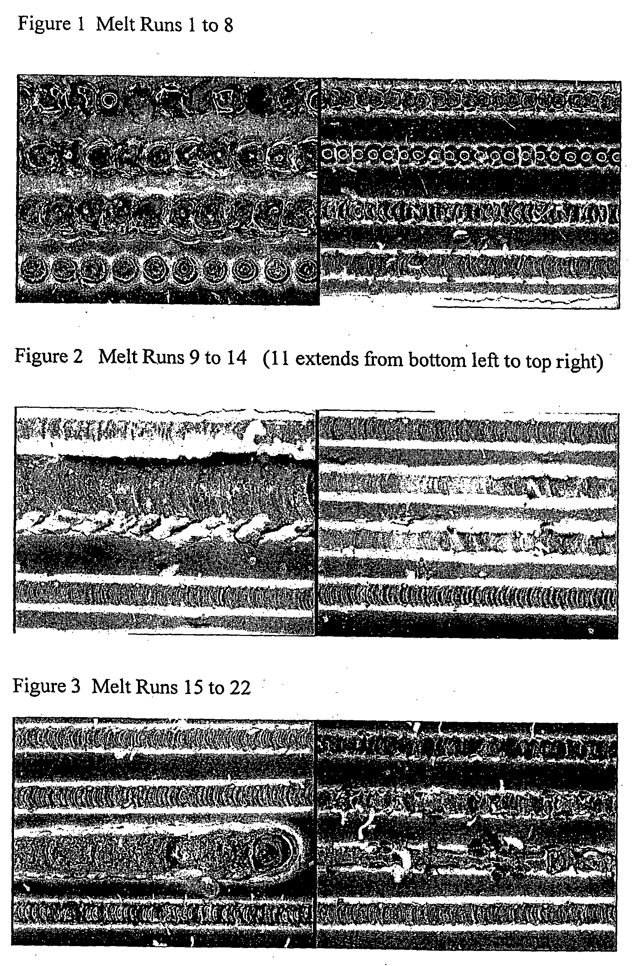

Particularly good results using silicon have been observed from the long pulse (0.1 ms to 20 ms Nd:YAG laser (@1064nm) having a peak power density in the range of 5 to 20 MW/cm². Even more specifically, when the laser has pulse duration of between 8 and 16 ms, peak power between 100 and 500 W, pulse energy between 1 and 4 J, a pulse repetition frequency of 3 to 16 pps, and an average power of 4.8 to 32 W. The following table details the various laser parameters for the tracks, using silicon and a 1064 Nd:YAG laser, illustrated in Figures 1 to 3.

**Table 1**

| Laser Parameters for Silicon Melt Runs of Figs. 1 to 3 | | | | | |
|---|---|---|---|---|---|
| **Track** | **Pulse Duration (ms)** | **Peak Power (W)** | **Pulse Energy (J)** | **PRF (pps)** | **Ave Power (W)** |
| 1 | .5 | 3000 | 1.5 | 1 | 1.5 |
| 2 | 1 | 1500 | 1.5 | 1 | 1.5 |
| 3 | 2 | 750 | 1.5 | 1 | 1.5 |
| 4 | 4 | 300 | 1.2 | 1 | 1.2 |
| 5 | 4 | 300 | 1.2 | 2 | 2.4 |
| 6 | 8 | 150 | 1.2 | 2 | 2.4 |
| 7 | 8 | 150 | 1.2 | 3 | 4.8 |
| 8 | 8 | 150 | 1.2 | 8 | 9.6 |
| 9 | 8 | 300 | 2.4 | 8 | 19.2 |
| 10 | 8 | 500 | 4 | 8 | 32 |
| 11 | 10 | 200 | 2 | 8 | 16 |
| 12 | 10 | 100 | 1 | 16 | 16 |
| 13 | 10 | 100 | 1 | 16 | 16 |
| 14 | 16 | 150 | 2.4 | 6 | 14 |
| 15 | 16 | 100 | 1.6 | 6 | 9.4 |
| 16 | 8 | 200 | 1.6 | 6 | 9.6 |
| 17 | 4 | 400 | 1.6 | 6 | 9.6 |
| 18 | 4 | 200 | 0.8 | 6 | 4.8 |
| 19 | 4 | 100 | 0.4 | 12 | 4.8 |
| 20 | 4 | 50 | 0.2 | 24 | 4.8 |
| 21 | 4 | 30 | 0.12 | 50 | 6 |

As can be seen from the Table, the laser pulse energy in tracks 1 to 4 remained essentially the same, but the peak power was reduced from 3kW to 1.5kW to 750W and 300W. The high peak power tracks show significant disturbance and ejected material. This material is brown in color and is therefore assumed to contain some elemental Silicon. At the lower peak powers, there is more evidence of material re-flow rather than ejection. There is also a white edge to the spots or tracks. This is also evident in Figure 2, and was presumed to be Silicon oxide. For track 5 the pulse repetition rate was doubled to 2 pps and again to 4 pps for track 7 and 8 pps for track 8. These tracks show the melting caused by single pulses joining into a coherent melt-run. The crack visible at the bottom of the right hand image in Figure 1 is the same one as appears at the top of the left-hand image in Figure 2 and may be caused by the run 10 which removed a significant amount of material. In the lower power runs, in particular nos. 12 & 13, the surface of the Silicon appears to have been "torn away".

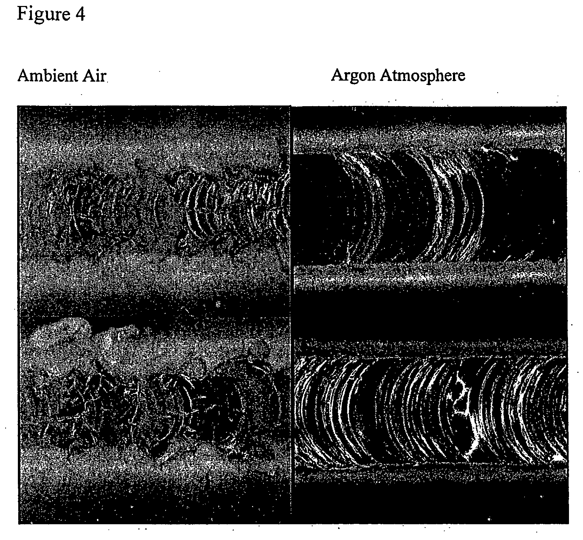

To avoid oxidation of the semiconductor material, it is highly recommended that the welding be carried out in an inert atmosphere, such as Argon, Nitrogen, Helium, Xenon, and Krypton. The inert atmosphere can be provided by simply flowing the inert gas over the fixation area or by positioning all of the elements in a sealed chamber flushed with an inert gas. Figure 4 illustrates the difference between a melt run in air and a melt run in an Argon atmosphere. The melt run in air displays uneven tearing on the surface, while the Argon run has a clear, almost metallic finish.

It was found experimentally that, when welding samples with polished face against polished face, if the gap between the edges to be welded was less than 10µm, there was a tendency for a crack to form in the bottom (center) of the weld. This effect appeared reproducible across about 10 samples. Conversely, using the same laser parameters, cracks did not form where the gap was >10µm.

Typical melt depths, which give adequate strength, are in the order of 100-150 µm for a 100 µm radius spot size and a translation speed of from 0.1mm/s to 1 mm/s.

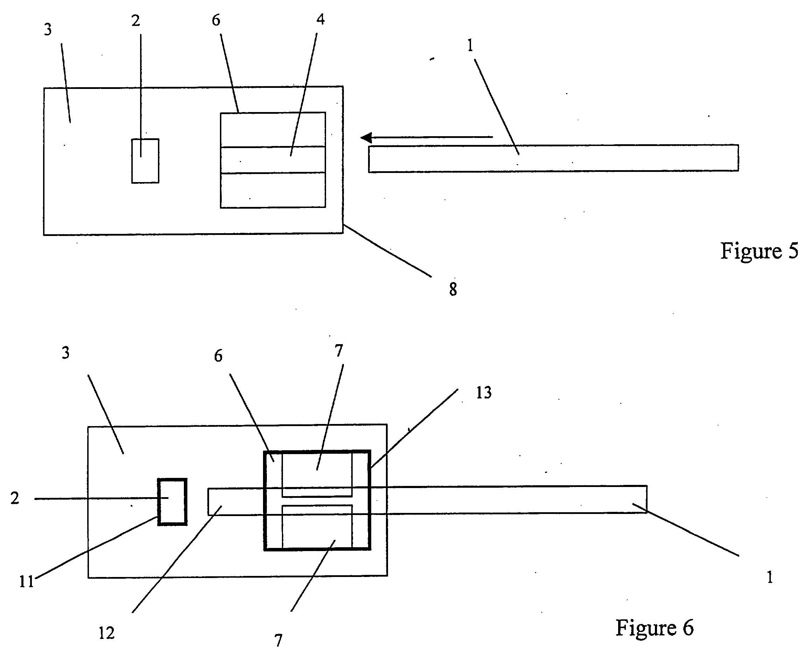

Figures 5 and 6 illustrate one form of a passive alignment system in which an optical fiber 1 is brought into alignment with an optical component, which is mounted on a semiconductor (Si, InP, GaN, SiC or GaAs) substrate 3. Initially, a groove 4 is provided for supporting the fiber 1 on the substrate 3. The groove 4 can be etched directly from the substrate 3 or alternatively can be provided in a separate fiber holder 6, which is mounted on the substrate 3. Next the optical component, e.g. a lens, a laser, a photodetector, a dichroic filter, a waveguide, a switch, a polarizer, a waveplate or a polarization rotator, is mounted in a structural component 2, which is constructed of the same material as the substrate, e.g. silicon, InP or GaAs. Then the structural component is positioned on the substrate 3 in a predetermined location in alignment with the groove 4. A fixation area is created at the intersection of the structural component 2 and the substrate 3. Subsequently, an optical beam, e.g. a laser (not shown), directs a beam at the fixation area, creating a joint 11, which fixes the structural component 2 to the substrate 3. The joint 11 is preferably a solid weld; however an intermittent weld or any other joint, e.g. brazing, with strength enough to hold the components together will do. Finally, the fiber 1 is positioned in the groove 4 and held therein, using mounting clips 7. The mounting clips 7 can take any form, however they preferably take the form of spring fingers extending from the sides of a groove 4 etched from the holder 6 or substrate 3. In this position minor adjustments can be made to the fiber, however, when the end 12 of the fiber 1 is satisfactorily aligned with the optical component, the fiber 1 is fixed to the mounting clips 7 using any known fixation process, including welding or the use of well-known solders or adhesives.

The fiber holder 6 can also be laser welded to the substrate 3 using the process according to the present invention resulting in weld 13. The weld 13 can either be a continuous weld or a series of intermittent welds. Accordingly, it is possible to use a laser welder to connect all of the components together without the need for any special coatings or adhesives.

In another embodiment, the welding step is divided into two or more steps, each step including directing the beam at only a portion of the total fixation area and making minor adjustments to the position of the structural component 2 until the optical component and the fiber 1 are optically aligned.

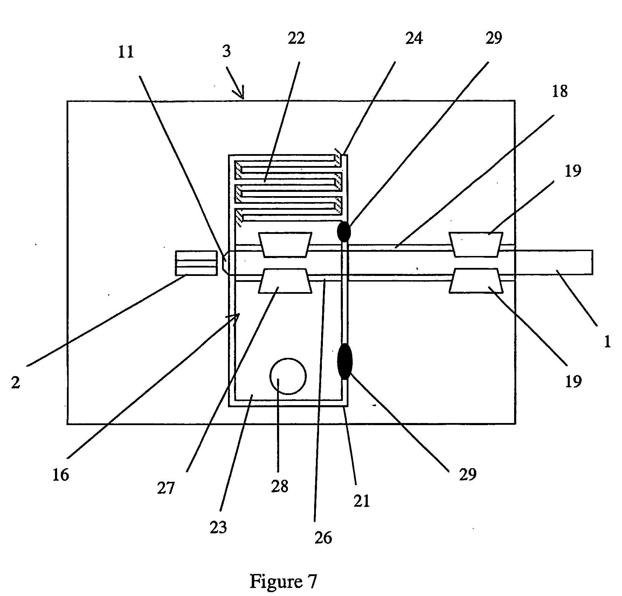

Figure 7 illustrates an example of a device, which has been aligned using an active alignment system. In this embodiment the optical fiber 1 is aligned with the optical component 2, mounted on the substrate 3, using a structural component in the form of a movable platform 16. The substrate 3 includes a groove 18 for receiving the fiber 1, and mounting clips 19 for securing the fiber 1 in the groove 18. In the illustrated embodiment the movable platform 16 is etched from the substrate 3 using a deep reactive ion etching (DRIE) process, creating a groove 21 therearound. The platform 16 is comprised of a spring portion 22 and a mounting portion 23. The spring portion 22 is in the form of a baffle spring, which has one end 24 extending from the wall of the groove 21. The mounting portion 23 includes a groove 26, aligned with groove 18, for receiving the fiber 1, and mounting clips 27 for securing the fiber 1 in the groove 26. The mounting portion 23 is also provided with a hole 28, which enables the mounting portion 23 to be engaged by an actuator (not shown). Movement of the platform 16 by the actuator enables the end 11 of the fiber 1 to be moved relative to the optical device 2 until sufficient optical coupling is established. When optical coupling above a predetermined threshold is achieved, a beam of light from a laser is directed at one or more fixation areas creating welds 29. In this case the two welded surfaces do not abut. Accordingly, the welds 29 span the groove 21 between the platform 16 and the substrate 3. After the platform 16 has been welded to the substrate 3, the end 24 of the baffle spring 22 is cut, thereby releasing any stress therein. In this case both the substrate 3 and the platform 16 may comprise integrated circuitry.

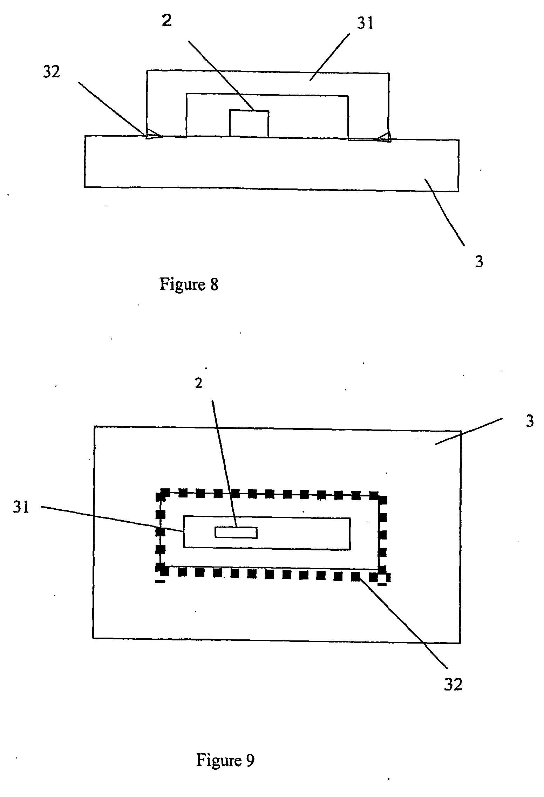

Figures 8 and 9 illustrate how the method of the present invention is used for hermetically sealing an optical component 2 on the substrate 3. In this case the structural component is a semiconductor (Si, InP, GaN, SiC or GaAs) cap 31, which is positioned over top of the optical component 2. The fixation area extends all the way around the cap 31, i.e. where the cap 31 meets the substrate 3. In the illustrated embodiment the optical component 2 is a photodiode, which uses the cap 31 as an optical window, i.e. the semiconductor cap is transparent to wavelengths between 1300 and 1500 nm. A lens (not shown) can also be provided integral with the cap 31 for directing the light. Dependent upon the ultimate use of optical component 2, the substrate 3 may comprise an integrated circuit (IC). The various electrical leads and optical waveguides can be coupled to the IC through hermetic metalized vias in the substrate 3 or cap 31. To hermetically seal the component 2, a laser with the aforementioned characteristics creates a semiconductor-to-semiconductor welded joint 32, corresponding to the fixation area, around the entire cap 31. The joint 32 may itself form the basis for an electrical contact.

## Claims

1. A method of joining a first semiconductor component to a second semiconductor component comprising the steps of:
a) providing the first and second semiconductor components;
b) positioning the first semiconductor component in close proximity to the second semiconductor component, thereby establishing a fixation area where the first and second components will be joined together;
c) directing an optical beam, at the fixation area with sufficient power to join adjacent portions on both the first and the second semiconductor components, together.

2. The method according to claim 1, wherein the first and second semiconductor components are comprised of one or more of the semiconductor materials selected from the group consisting of Silicon (Si), Indium Phosphide (InP), and Gallium Arsenide (GaAs).

3. The method according to claim 1, wherein the first semiconductor component is a semiconductor micro-bench on which the second semiconductor component is mounted.

4. The method according to claim 3, wherein the second semiconductor component is a cap, having an outer surface, for hermetically sealing an optical component on the micro-bench; and wherein the fixation area extends around the cap where the outer surface of the cap meets the micro-bench.

5. The method according to claim 3, wherein the second semiconductor component is an arm etched from the first component; and wherein the fixation area includes an edge of the arm, an edge of the micro-bench, and a groove separating the arm from the micro-bench.

6. The method according to claim 3, wherein the second semiconductor component supports an optical element therein; and wherein the fixation area comprises an edge of the second semiconductor component and a surface of the micro-bench.

7. The method according to claim 1, wherein the optical beam is a laser beam.

8. The method according to claim 7, wherein the laser beam has a peak power density in the range of 5 to 20 MW/cm².

9. The method according to claim 7, wherein the laser beam has a fundamental wavelength of between 150 nm and 5000 nm

10. The method according to claim 7, wherein the laser beam has a wavelength of 1064 nm and originates from a long pulse Nd:YAG laser.

11. The method according to any one of claims 1 to 10, further comprising flushing the fixation area with an inert gas during step c).

12. The method according to any one of claims 1 to 10, wherein step c) welds or brazes the first semiconductor component to the second semiconductor component forming a joint therebetween.

13. The method according to any one of claims 1 to 10, wherein step c) includes:
joining only a part of the entire fixation area;
adjusting the position of the second semiconductor component; and
joining the remainder of the fixation area.
